# EUROPEAN PATENT SPECIFICATION

(11) **EP 4 243 044 B1**
(45) Date of publication and mention of the grant of the patent: **14.05.2025**
(21) Application number: 23155545.9
(22) Date of filing: 08.02.2023
(51) Int. Cl.: H01H 13/14, H01H 13/64, G01R 31/28

(54) **RADIO FREQUENCY CIRCUIT HAVING ERROR DETECTION CAPABILITY**
HOCHFREQUENZSCHALTUNG MIT FEHLERERKENNUNGSFÄHIGKEIT
CIRCUIT RADIOFRÉQUENCE AVEC CAPACITÉ DE DÉTECTION D'ERREUR

(30) Priority: 20.02.2022 US 202263312061 P; 11.11.2022 TW 111143293
(43) Date of publication of application: 13.09.2023
(73) Proprietor: TMY Technology Inc., Taipei City 106 (TW)
(72) Inventor: CHANG, Su-Wei, 106 Taipei City (TW)
(74) Representative: Becker, Eberhard

(56) References cited:
- EP-A1- 2 866 040
- EP-A1- 3 611 522
- US-A1- 2003 061 701
- US-A1- 2006 234 634
- PROBST STEFFEN ET AL: "In Situ Waveform Measurements Within Doherty Power Amplifier Under Operational Conditions", IEEE TRANSACTIONS ON MICROWAVE THEORY AND TECHNIQUES, IEEE, USA, vol. 65, no. 6, 1 June 2017 (2017-06-01), pages 2192 - 2200, XP011651220, ISSN: 0018-9480, [retrieved on 20170602], DOI: 10.1109/TMTT.2017.2651809
- YOON SANG-WOONG ET AL: "Efficient Wi-Fi Power Amplifier LTCC Module Using a Buck Converter With a Power Inductor Implemented in Ferrite-Filled PCB Technology", IEEE TRANSACTIONS ON COMPONENTS, PACKAGING AND MANUFACTURING TECHNOLOGY, IEEE, USA, vol. 5, no. 7, 1 July 2015 (2015-07-01), pages 887 - 894, XP011663673, ISSN: 2156-3950, [retrieved on 20150717], DOI: 10.1109/TCPMT.2015.2443020
- LIN LIANG ET AL: "Shielding cover effects on the RF performance of LDMOSFET power amplifier for WCDMA application", 2013 ASIA-PACIFIC MICROWAVE CONFERENCE PROCEEDINGS (APMC), IEEE, 5 November 2013 (2013-11-05), pages 609 - 611, XP032549272, DOI: 10.1109/APMC.2013.6694880

## Description

### BACKGROUND

### Technical Field

The disclosure relates to a radio frequency circuit, and more particularly, to a radio frequency circuit having error detection capability.

### Description of Related Art

Radio frequency circuits have been widely used in electronic devices such as mobile phones, tablet computers, wearable apparatuses, and smart assistant apparatuses. A radio frequency circuit usually includes multiple electronic elements. If the electronic element malfunctions before leaving the factory or after it is sold, the operation of the radio frequency circuit will be affected. However, the malfunction of individual elements is sometimes difficult to confirm, and the traditional detection method is difficult to operate in time in the actual operation of the radio frequency circuit, and it is often necessary to disassemble the entire circuit and then test the elements one by one.

EP 3611522 Al relates to an embedded test circuitry including a circuit for testing failure of a connection between a radio frequency, RF, integrated circuit and external circuitry.

### SUMMARY

In view of this, the embodiment of the disclosure provides a radio frequency circuit having error detection capability. Using the characteristics of crosstalk of the RF/HF transmission line and the corresponding circuit design, a radio frequency circuit having element/signal error detection capability is realized without dismantling the machine.

The invention is set out in the appended set of claims. The following disclosure serves a better understanding of the present invention.

In order to make the above-mentioned features and advantages of the disclosure comprehensible, embodiments accompanied with drawings are described in detail below.

### BRIEF DESCRIPTION OF THE DRAWINGS

FIG. 1 is a block diagram of elements of a radio frequency (RF) circuit according to an embodiment of the disclosure.
FIG. 2A is a perspective schematic view according to the configuration of a transmission line and a sensing line of an embodiment of the disclosure.
FIG. 2B is a cross-sectional view of FIG. 2A along a sectional line A-A
FIG. 2C is a partial cross-sectional view of a radio frequency circuit according to an embodiment of the disclosure.
FIG. 2D is a partial cross-sectional view of a radio frequency circuit according to an embodiment of the disclosure.
FIG. 3A is a partial circuit diagram of a radio frequency circuit in response to a connector being not connected to a sensor according to an embodiment of the disclosure.
FIG. 3B is a partial circuit diagram of a radio frequency circuit in response to a connector being connected to a sensor according to an embodiment of the disclosure.
FIG. 4A is a partial circuit diagram of a radio frequency circuit in response to a connector being not connected to a sensor according to another embodiment of the disclosure.
FIG. 4B is a partial circuit diagram of the radio frequency circuit in response to a connector being connected to a sensor according to another embodiment of the disclosure.
FIG. 5 is a circuit diagram of a sensor according to an embodiment of the disclosure.
FIG. 6A is a schematic view of performing error detection on a multiplexer according to an embodiment of the disclosure.
FIG. 6B is a schematic view illustrating crosstalk phenomenon according to an embodiment of the disclosure.
FIG. 7A is a schematic view of performing error detection on multiple transmission lines according to an embodiment of the disclosure.
FIG. 7B is a schematic view of the configuration of sensing lines according to an embodiment of the disclosure.
FIG. 7C is a schematic view of the configuration of sensing lines according to another embodiment of the disclosure.
FIG. 8 is a schematic view of performing error detection on an amplifier according to an embodiment of the disclosure.

### DETAILED DESCRIPTION OF THE EMBODIMENTS

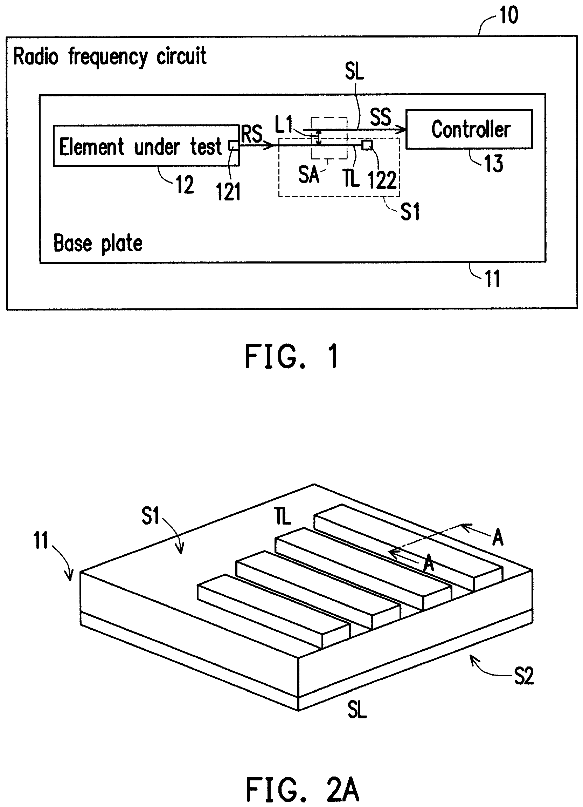

FIG. 1 is a block diagram of elements of a radio frequency (RF) circuit 10 according to an embodiment of the disclosure. Referring to FIG. 1, the radio frequency circuit 10 includes (but not limited to) a base plate 11, one or more element under test 12, one or more transmission line TL, one or more sensing line SL, and a controller 13. The radio frequency circuit 10 is applied in communication transceivers supporting mobile network, Wi-Fi, Bluetooth, or other communication protocols.

The base plate 11 may be the body of the printed circuit board or other support or carrier of an electronic element. In an embodiment, the base plate 11 includes a first surface S1. In another embodiment, in addition to the first surface S1, the base plate 11 further includes a second surface opposite to the first surface S1 (to be explained in the subsequent embodiment).

The element under test 12 is disposed on the base plate 11. The element under test 12 may be a multiplexer, a low noise amplifier (LNA), a phase shifter, a mixer, a frequency divider, a switch, a filter or other electronic elements. The element under test 12 has one or more output ports 121 to output an RF signal RS. According to different design requirements, a carrier frequency of the RF signal RS may range from 300 MHz to 300 GHz, but not limited thereto.

The transmission line TL is disposed on the first surface S1 of the base plate 11 and electrically connected to the output port 121 of the element under test 12. The transmission line TL may be copper or other metals, alloys, or metal compound wires for carrying the RF signal RS.

In an embodiment, the radio frequency circuit 10 further includes a secondary element 122. The secondary element 122 is electrically connected to the transmission line TL to receive the RF signal RS. The second element 122 is, for example, an antenna, a filter (circuit), a mixer, or any other active or passive electronic circuit or electronic element that is capable of receiving an RF signal.

The sensing line SL is disposed on the base plate 11. The sensing line SL is substantially parallel to the transmission line TL within a sensing area SA of the base plate 11. That is, in the circuit wiring, at least the line segment of the sensing line SL in the sensing area SA is substantially parallel to a part of the line segment of the transmission line TL. However, outside the sensing area SA, the sensing line SL and the transmission line TL are not limited to parallel arrangements in space.

In addition, inside the sensing area SA, the sensing line SL and the transmission line TL are separated by a first length L1. In an embodiment, the first length L1 is about one-eighth of a line width of the transmission line TL line to the line width of the transmission line TL.

It is worth noting that, based on the characteristics that the transmission line TL and the sensing line SL are parallel to each other and separated apart, a capacitance coupling or an inductive coupling is to exist between the lines. Alternatively, it is called crosstalk or inductive coupling. Therefore, the sensing line SL is adapted for inducing the RF signal RS on the transmission line TL, and may generate an induction signal SS accordingly. That is, in response to the RF signal RS passing through the sensing area SA, the sensing line SL generates the induction signal SS in the induction area SA based on the coupling phenomenon.

In an embodiment, both the transmission line TL and the sensing line SL are disposed on the first surface S1 of the base plate 11. That is, the transmission line TL and the sensing line SL are located on the same layer.

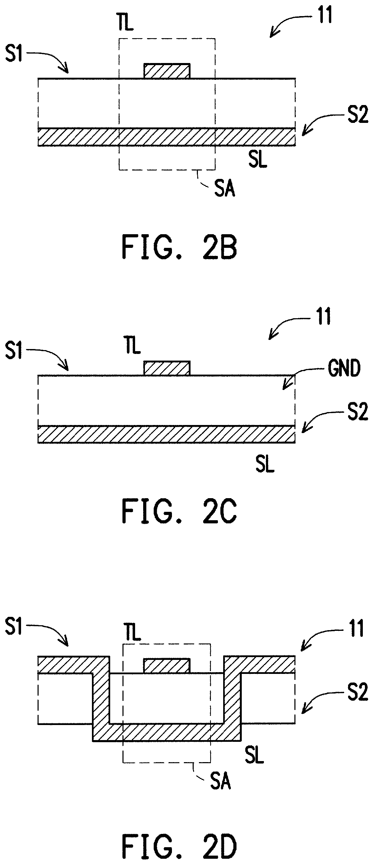

FIG. 2A is a perspective schematic view according to the configuration of the transmission line TL and the sensing line SL of an embodiment of the disclosure, and FIG. 2B is a cross-sectional view of FIG. 2A along a sectional line A-A. Referring to FIG. 2A and FIG. 2B, the transmission line TL is disposed on the first surface S1 of the base plate 11, and the sensing line SL is disposed on the second surface S2 of the base plate 12. The pitch of the first surface S1 and the second surface S2 is the first length L1. That is, the transmission line TL is located on a first layer, and the sensing line SL is located on a second layer.

FIG. 2C is a partial cross-sectional view of the radio frequency circuit 10 according to an embodiment of the disclosure. Referring to FIG. 2C, in some embodiments, outside the sensing area SA of base plate 11, a third layer between the first surface S1/first layer and the second surface S2/second layer is connected to a ground GND and used as a ground layer. That is, the ground layer is sandwiched between the first surface S1/first layer and the second surface S2/second layer.

FIG. 2D is a partial cross-sectional view of the radio frequency circuit 10 according to an embodiment of the disclosure. Referring to FIG. 2D, in some embodiments, the sensing line SL may penetrate the base plate 11. Thus, a part of the sensing line SL is disposed on the first surface S1 of the base plate 11 and penetrating the base plate 11, so that another part of the sensing line SL is disposed on the second surface S2 of the sensing area SA of the base plate 11. That is, the sensing line SL goes around the sensing area SA to the other side of the first surface S1 where the transmission line TL is located.

Referring to FIG. 1, the controller 13 is disposed on the base plate 11 and electrically connected to the sensing line SL. The controller 13 may be a central processing unit (CPU), programmable general-purpose or special-purpose microprocessors, a digital signal processor (DSP), a programmable controller, a field programmable gate array (FPGA), an application-specific integrated circuit (ASIC), or other similar components, or combinations of components thereof.

In an embodiment, the controller 13 is configured to determine the state of the element under test 12 according to the induction signal SS from the sensing line SL. The states of element under test 12 are, for example, a malfunction state, a normal state, an energy-saving state, or a high-efficiency state. According to different design requirements, the controller 13 may determines whether the element under test 12 is in a malfunction state or in a normal state according to the existence, intensity, frequency, or other physical characteristics of induction signal SS, and application situations thereof are described in subsequent embodiments.

In an embodiment, the radio frequency circuit 10 further includes a sensor (to be explained in the subsequent embodiment). The sensor is disposed on base plate 11. The sensor is electrically connected to the sensing line SL and the controller 13. The sensor is configured to convert the induction signal SS. The converted signal is used by the controller 13 to determine the state of the element under test. The conversion by the sensor may be gain adjustments, filtering, and/or analog-to-digital conversion.

In an embodiment, the sensor is directly connected to the sensing line SL.

In another embodiment, the radio frequency circuit 10 may provide a detachable structure. For example, the radio frequency circuit 10 further includes a connector. The connector is located on the base plate 11 and coupled to the sensing line SL, and is adapted for connecting the sensor. In response to the connector being connected to the sensor and the sensing line SL has the induction signal SS, the sensor may receive the induction signal SS.

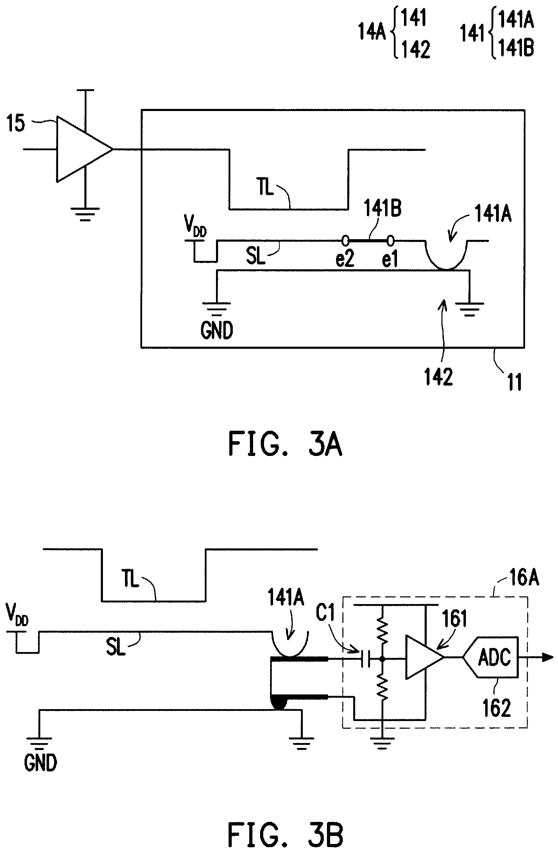

For example, FIG. 3A is a partial circuit diagram of the radio frequency circuit 10 in response to a connector 14A being not connected to a sensor 16A according to an embodiment of the disclosure, and FIG. 3B is a partial circuit diagram of the radio frequency circuit 10 in response to the connector 14A being connected to the sensor 16A according to an embodiment of the disclosure. Referring refer to FIG. 3A, the connector 14A includes a first conductive structure 141 and a second conductive structure 142.

The first conductive structure 141 is electrically connected to the sensing line SL. The second conductive structure 142 is electrically connected to a first voltage source on the base plate 11 to receive a first voltage. The first voltage may be a system voltage V_{DD}, and the first voltage source may be a power supply, a battery, or a power converter. However, the first voltage may also be other custom voltages.

In an embodiment, at least one of the first conductive structure 141 and the second conductive structure 142 includes a bendable or elastic member, which may be deformed by an external force. Referring to FIG. 3A, in response to the connector 14A being not connected to the sensor 16A, at least one of the first conductive structure 141 and the second conductive structure 142 is located in a first position due to the reset force, so that the first conductive structure 141 and the second conductive structure 142 are in a clamping state. That is, the first conductive structure 141 and the second conductive structure 142 are against each other.

Referring to FIG. 3B, in response to the connector 14A being connected to the sensor 16A, at least one of the first conductive structure 141 and the second conductive structure 142 is pushed by a terminal of the sensor 16A to a second position, so that the first conductive structure 141 and the second conductive structure 142 clamp the sensor 16A.

More specifically, in an embodiment, the first conductive structure 141 includes a first conductor reed 141A and a first conductor plate 141B. The first conductor reed 141A is bendable by an external force. The first conductor plate 141B is disposed fixedly on the base plate 11 and includes a first end e1 and a second end e2. The first end e1 of the first conductor plate 141B is connected to one end of the first conductor reed 141A. The second end e2 of the first conductor plate 141B is connected to the sensing line SL.

Referring to FIG. 3A, in response to the connector 14A being not connected to the sensor 16A, the first conductor reed 141A and the second conductive structure 142 form the clamping state. For example, the first conductor reed 141A abuts against the second conductive structure 142. At this time, the sensing line SL is connected to the ground GND.

Referring to FIG. 3B, in response to the connector 14A being connected to the sensor 16A, the first conductor reed 141A and the second conductive structure 142 clamp the sensor 16A. For example, the first conductor reed 141A and the second conductive structure 142 abut against the sensor 16A.

On the other hand, the sensor 16A includes (but not limited to) a capacitor C1, an amplifier 161, and an analog to digital converter (ADC) 162. Referring to FIG. 3B, in response to the connector 14A being connected to the sensor 16A, the system voltage V_{DD} is further connected to the ground GND through the capacitor C1 and a bleeder circuit.

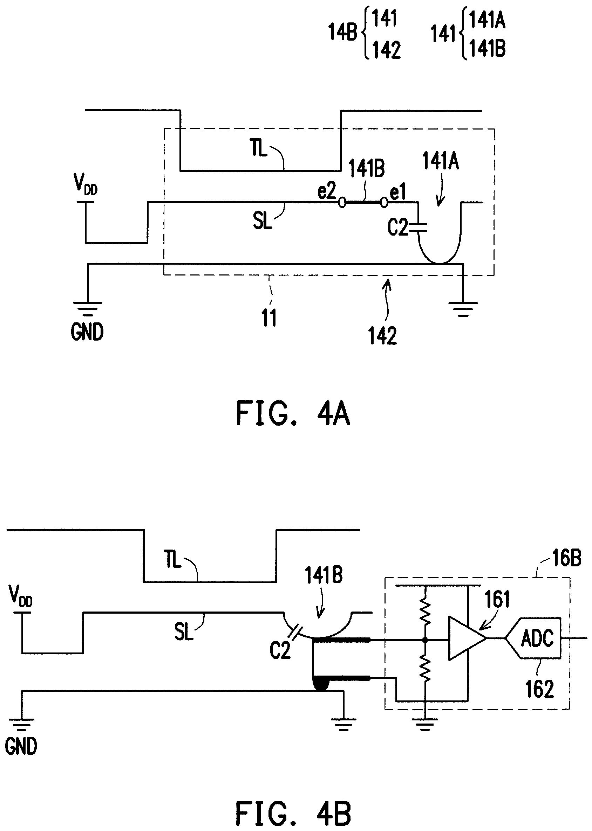

FIG. 4A is a partial circuit diagram of the radio frequency circuit 10 in response to a connector 14B being not connected to the sensor 16B according to another embodiment of the disclosure, and FIG. 4B is a partial circuit diagram of the radio frequency circuit 10 in response to the connector 14B being connected to the sensor 16B according to another embodiment of the disclosure. Referring to FIG. 4A and FIG. 4B, the difference from FIG. 3A and FIG. 3B is that the connector 14B further includes a capacitor C2, and the sensor 16B does not include the capacitor C1. Thus, in response to the connector 14B being connected to the sensor 16B, the system voltage V_{DD} is further connected to the ground GND through the capacitor C2 and the bleeder circuit of the sensor 16B.

It should be noted that in other embodiments, the connector is not limited to two conductive structures, and the conductive structure is not limited to reed and plate. For example, a plug-in connector. Since the other end corresponding to the sensing line SL is electrically connected to a DC power to obtain a fixed voltage, the sensing line SL is used as the ground GND or the fixed voltage in response to the connectors 14A and 14B being not inserted, thereby reducing the impact of the floating circuit on the characteristics of the main signal line (e.g., transmission line TL). For another example, more conductive structures may be provided.

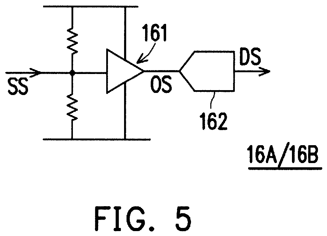

FIG. 5 is a circuit diagram of a sensor 16A/16B according to an embodiment of the disclosure. Referring to FIG. 5, the sensor 16A/16B is a peak detector or a power sensor. In response to the connector being connected to the sensor 16A/16B, the sensor is adapted for generating a determination signal DS according to the induction signal SS. More specifically, the amplifier 161 of the sensor 16A/16B is configured to amplify the induction signal SS to generate an output signal OS. An analog to digital converter 162 is coupled to the amplifier 161. The analog to digital converter 162 is configured to convert the output signal OS output by the amplifier 161 into a determination signal DS in digital form.

The controller 13 may read the output value of the sensor 16A/16B to generate the determination signal DS. In an embodiment, the controller 13 may be a determination circuit with an analog to digital converter.

In addition, the controller 13 may determine the state of the element under test 12 according to the determination signal DS. For example, the determination signal DS "0" represents a malfunction state, while the determination signal DS "1" represents an operation state. However, the corresponding relationship between the determination signal DS and the state of element under test 12 may still be changed according to actual needs.

In other embodiments, the sensors 16A and 16B may be integrated in the controller 13.

In an embodiment, the controller 13 is also configured to connect to a communication transceiver (not shown). The communication transceiver may be a transceiver circuit supporting Wi-Fi, mobile network, Bluetooth, optical fiber network, or other communication protocols. The communication transceiver is configured to transmit a malfunction state or the induction signal SS determined by the controller 13. In this way, the state of the element under test 12 is known. In other embodiments, the malfunction state or the induction signal SS is also prompted through a display or a speaker.

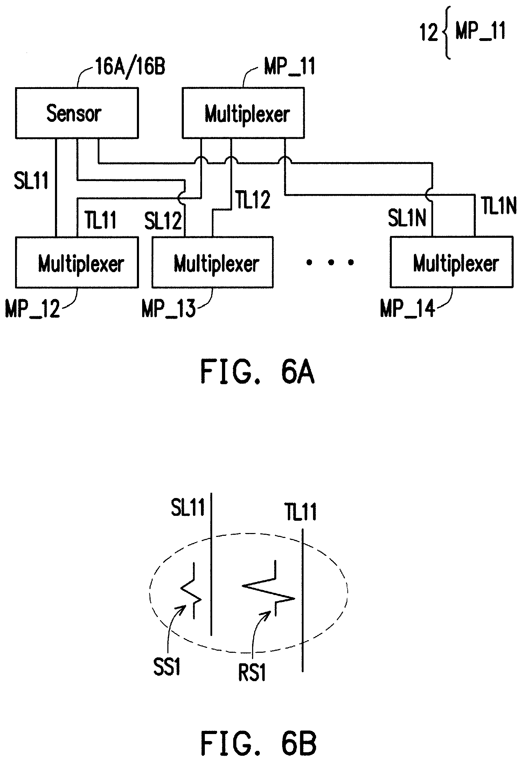

FIG. 6A is a schematic view of performing error detection on a multiplexer MP_11 according to an embodiment of the disclosure. Referring to FIG. 6A, the element under test 12 is the multiplexer MP_11 from 1 to N. N is a positive integer. The multiplexer MP_11 includes an output port 121 ofN, and is connected to transmission lines TL11, TL12,..., TL1N, respectively. The transmission lines TL11, TL12,..., TL1N are respectively connected to multiplexers MP_12, MP_13, and MP_14. In addition, the sensing lines SL11, SL12,..., SL1N are substantially parallel to the transmission lines TL11, TL12,..., TL1N within the sensing area SA, respectively. The sensing lines SL11, SL12,..., SL1N are connected to the sensor 16A/16B.

Taking the transmission line TL11 and the sensing line SL11 as examples, in response to the case that the multiplexer MP_11 transmits the RF signal RS to the multiplexer MP_12 while the sensing line SL11 does not generate the induction signal SS (i.e., an induction failure), the controller 13 determines that the multiplexer MP_11 (i.e., the element under test) is in a malfunction state. For example, an output circuit connected to the transmission line TL11 is malfunctioning. For another example, an input circuit of the multiplexer MP_12 is malfunctioning.

FIG. 6B is a schematic view illustrating crosstalk phenomenon according to an embodiment of the disclosure. Referring to FIG. 6A and FIG. 6B, in response to the case that the multiplexer MP_11 transmits an RF signal RS1 to the multiplexer MP_12 and the sensing line SL11 generates an induction signal SS1, the controller 13 determines that the multiplexer MP_11 is in a normal state. It should be noted that the basis for determining whether the sensing line SL11 generates the induction signal SS1 may be the comparison result with a corresponding threshold value. The corresponding threshold value may have, for example, one-tenth, one-hundredth, or other constants of the power intensity of the RF signal RS1, and/or may be related to the length between the sensing line SL11 and the transmission line TL11 and the intensity of the inductive coupling. Alternatively, it may be determined whether the waveform of the induction signal SS1 is the same as the waveform of the RF signal RS1.

In addition, besides the induction signal SS1 generated by the sensing line SL11, any one of the sensing lines SL12,..., SL1N also generates the induction signal SS at the same time, so a leakage may occur between the transmission lines TL11, TL12,..., TL1N.

Similarly, the multiplexer MP_11 may transmit the RF signal RS to the multiplexers MP_13 and MP_14 respectively and determine whether the induction signal SS is generated on the corresponding sensing lines SL12 and SL1N, and details are not repeated herein.

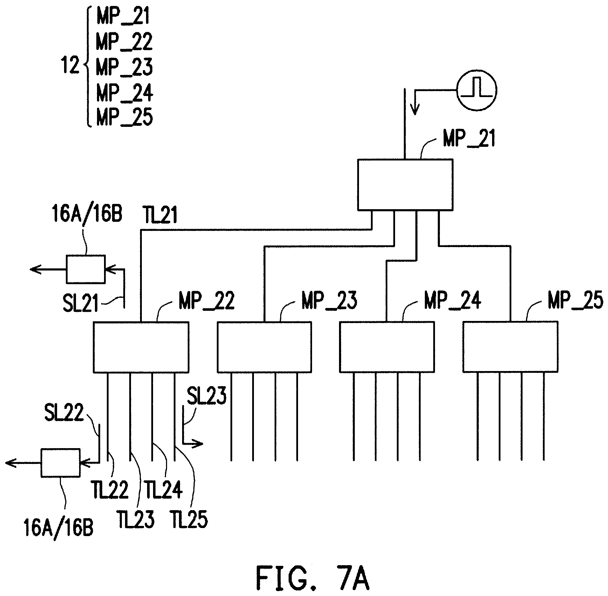

FIG. 7A is a schematic view of performing error detection on multiple transmission lines TL21, TL12,..., TL25 according to an embodiment of the disclosure. Referring to FIG. 7A, the element under test 12 are multiplexers MP_21, MP_22, MP_23, and MP_24 of 1 to 4. Four output ports 121 of the multiplexer MP_21 are respectively connected to the multiplexers MP_22, MP_23, MP_24, and MP_25. The sensing line SL21 is substantially parallel to the transmission line TL21 within the sensing area SA. The sensing line SL21 is connected to the sensor 16A/16B.

Similarly, in response to the multiplexer MP_21 transmits the RF signal RS to the multiplexer MP_22, whether the multiplexer MP_21 and/or MP_22 is malfunctioning is determined by whether the sensor 16A/16B receives the induction signal SS on the sensing line SL21.

After confirming that the multiplexer MP_22 receives the RF signal RS from the multiplexer MP_21, the determination of whether the output of the multiplexer MP_22 is normal is continued. Four output ports 121 of the multiplexer MP_22 are respectively connected to transmission lines TL22, TL23, TL24, and TL25. Sensing lines SL22 and SL23 are substantially parallel to the transmission lines TL22, TL23, TL24 and TL25 within the sensing area SA. The sensing lines SL22 and SL23 are connected to the sensor 16A/16B.

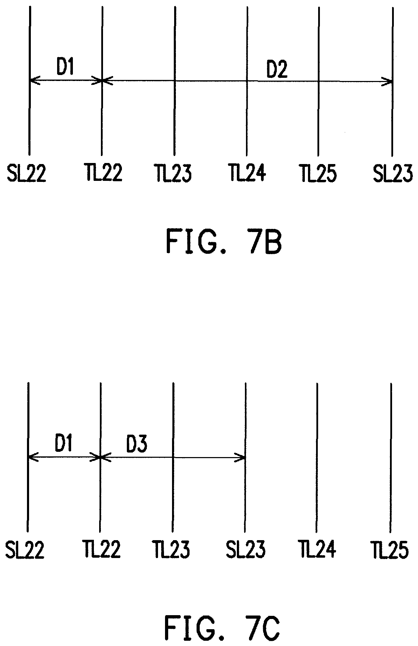

FIG. 7B is a schematic view illustrating the configuration of the sensing lines SL22 and SL23 according to an embodiment of the disclosure. Referring to FIG. 7B, the sensing lines SL22 and SL23 are located outside of the transmission lines TL22, TL23, TL24, and TL25. Compared with the sensing line SL22, the sensing line SL23 is regarded as an additional sensing line. Compared with the transmission line TL22, the transmission lines TL23, TL24, and TL25 are regarded as additional transmission lines. The sensing lines SL22 and SL23 are adapted for inducing the RF signal RS on the transmission lines TL22, TL23, TL24, and TL25 to generate the induction signal SS and determining the state of the multiplexer MP_22 accordingly.

A first output port of the multiplexer MP_22 transmits the RF signal RS through the transmission line TL22. In response to a power intensity of the induction signal SS of the transmission line TL22 being less than a first threshold value, the controller 13 may determine that the multiplexer MP_22 is in a malfunction state. In addition, in response to the power intensity of the induction signal SS of the transmission line TL22 being not less than the first threshold value, the controller 13 may determine that the multiplexer MP_22 is in a normal state.

The controller 13 simultaneously induces the RF signal RS of the transmission line TL22 through the sensing lines SL22 and SL23. The degree of the influence of the coupling phenomenon may depend on the distance. Thus, for the RF signal RS on different transmission lines TL22~TL23, the power intensity of the induction signal SS on the sensing lines SL22 and SL23 may be different. Generally, the farther the distance between the transmission line TL and the sensing line SL is, the weaker the power intensity of the induction signal SS on the sensing line SL; and the shorter the distance between the transmission line TL and the sensing line SL is, the greater the power intensity of the induction signal SS on the sensing line SL. The first threshold value is the basis for evaluating whether to generate an induction signal. Thus, distances D1 and D2 from the first threshold value and the transmission line TL22 to the sensing lines SL22 and SL23 respectively have a weight relationship. For example, D2 is 4 times D1. The length of the distance between adjacent transmission lines TL22~TL25 is D1. For the RF signal RS on the transmission line TL22, the first threshold value corresponding to the sensing line SL22 may be about 4 times the first threshold value corresponding to the sensing line SL23. In addition, the first threshold value is also related to the intensity of the inductive coupling of the sensing lines SL22 and SL23.

On the other hand, in response to the intensity of the induction signal of the sensing line SL22 being about 4 times the intensity of the induction signal of the sensing line SL23, it is determined that the RF signal RS is transmitted through the transmission line TL22. In response to the intensity of the induction signal of the sensing line SL23 being about 4 times the intensity of the induction signal of the sensing line SL22, it is determined that the RF signal RS is transmitted through the transmission line TL25. In response to the intensity of the induction signal of the sensing line SL22 being slightly stronger than the intensity of the induction signal of the sensing line SL23, it is determined that the RF signal RS is transmitted through the transmission line TL23. In response to the intensity of the induction signal of the sensing line SL22 being slightly weaker than the intensity of the induction signal of the sensing line SL23, it is determined that the RF signal RS is transmitted through the transmission line TL24. In this way, only two sensing lines is deployed to determine whether the switch/element corresponding to the four transmission lines is operating normally.

It should be noted that adjacent lines of the microstrip and adjacent lines of the stripline may cause near-end noises with different decreasing degrees as the pitch increases. Compared with the microstrip, the near-end noise of the stripline decreases significantly as the pitch increases. In order to allow a certain degree of near-end crosstalk between adjacent lines, the pitch between adjacent lines is twice the line width, but not limited thereto. In addition, the intensity of the induction signal is approximately inversely proportional to the 1.5th power to the 2nd power of the pitch, but not limited thereto.

However, the configuration of the sensing lines SL22 and SL23 is not limited to that shown in FIG. 7B. FIG. 7C is a schematic view illustrating the configuration of the sensing line SL22 and SL23 according to another embodiment of the disclosure. Referring to FIG. 7C, the difference from FIG. 7B is that the sensing line SL23 is located between the transmission lines TL23 and TL24. Similarly, distances D1 and D3 from the first threshold value and the transmission line TL22 to the sensing lines SL22 and SL23 respectively have a weight relationship. For example, D3 is 2 times D1. For the RF signal RS on the transmission line TL22, the first threshold value corresponding to the sensing line SL22 may be about 2 times the first threshold value corresponding to the sensing line SL23.

In addition, in response to the multiplexer MP_22 transmitting the RF signal RS through the transmission line TL22 and the power intensity of the induction signal SS of the transmission line TL23 being less than a second threshold value, the controller 13 may determine that no leakage occurs between the transmission lines TL22 and TL23. In response to the multiplexer MP_22 transmitting the RF signal RS through the transmission line TL22 and the power intensity of the induction signal SS of the transmission line TL23 being not less than the second threshold value, the controller 13 may determine that the leakage occurs between the transmission lines TL22 and TL23. Similarly, the distance from the second threshold value and the transmission line TL23 to the sensing lines SL22 and SL23 respectively may have a weight relationship.

Taking FIG. 7C as an example, in response to the multiplexer MP_22 transmitting the RF signal RS through the transmission line TL22, the voltage of the induction signal SS on the sensing line SL22 should be greater than 0.5 volts, but the sensing line SL23 should not be able to generate the induction signal SS since the distance is too far. At this time, in response to the voltage of the induction signal SS on the sensing line SL23 still being greater than 0.4 volts, there may be a leakage of electric current on the transmission line TL23 induced by the sensing line SL23 due to the leakage. That is, in response to the transmission line TL22 transmitting the RF signal RS, the leakage is determined through the sensing line SL23 adjacent to another transmission line TL23.

The RF signal RS on the transmission lines TL23, TL24, and TL25 may be referred to the description of the aforementioned RF signal RS on the transmission line TL22, which will not be repeated herein. That is, the different power intensities of the induction signal SS of the sensing lines SL22 and SL23 may reflect that there are RF signals on different transmission lines TL22, TL23, TL24, and TL25. In addition, the amount and configuration of the sensing line are not limited to the embodiments shown in FIG. 7B and FIG. 7C. Thereby, more transmission lines TL22~TL25 is induced by fewer sensing lines SL22 and SL23.

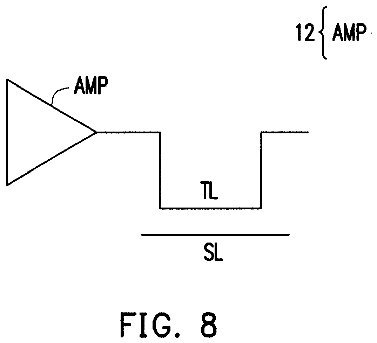

FIG. 8 is a schematic view of performing error detection on an amplifier AMP according to an embodiment of the disclosure. Referring to FIG. 8, the element under test 12 is the amplifier AMP (e.g., LNA). The output port 121 of the amplifier AMP is connected to the transmission line TL, and part of the line segment of the transmission line TL is substantially parallel to the sensing line SL. In response to the power intensity of the induction signal SS of the output port of the amplifier AMP being less than a third threshold value, the controller 13 may determine that the amplifier AMP is in a malfunction state. In response to the power intensity of the induction signal SS of the output port of the amplifier AMP being not less than the third threshold value, the controller 13 may determine that the amplifier AMP is in a normal state. The third threshold value is determined according to a gain of the amplifier AMP. Since one of the purposes of the amplifier AMP is to adjust the gain of the input signal, the induction signal SS generated by the coupling of the RF signal RS output by the amplifier AMP should also have a corresponding power intensity.

For example, the amplifier AMP may ideally amplify the signal power by 10 dB, and the coupling ratio between the induction signal SS and the RF signal RS is 1/10. In response to an input signal with -10 dBm being input to the amplifier AMP, the power of the induction signal SS should be -10 dBm. In response to the power of the induction signal SS of -11 dBm, the gain of the amplifier AMP is only 9 dB, which is less than the ideal 10 dB. The difference between the actual gain and the ideal gain may be caused by the non-ideality of the amplifier AMP. Since this kind of non-ideality may change with time, this embodiment allows the radio frequency circuit to adjust itself according to the current reading value, and provide corresponding gain compensation or other controls.

It should be noted that for different types of the element under test 12, the basis for determining the state of the element under test 12 is not limited to power intensity. For example, assuming that the element under test 12 is a mixer or a frequency divider, the frequency of the induction signal SS is used for determination. For another example, assuming that the element under test 12 is a phase shifter, the phase of the induction signal SS is used for determination.

To sum up, in the radio frequency circuit having error detection capability in the embodiment of the disclosure, a sensing line substantially parallel and a transmission line connected to the output port of the element under test are disposed in the sensing area. The induction signal generated by the sensing line due to crosstalk is used for determining the state of the element under test. In this way, the error detection capability is achieved without greatly affecting the overall circuit structure.

## Claims

1. A radio frequency (RF) circuit (10) having error detection capability, comprising:
a base plate (11), having a first surface (S1);
an element under test (12), disposed on the base plate (11), comprising an output port (121) to output an RF signal (RS, RS1);
a transmission line (TL, TL11~TL1N, TL21~TL25), disposed on the first surface (S1) of the base plate (11) and electrically connected to the output port (121) of the element under test (12);
a sensing line (SL, SL11~SLIN, SL21~SL23), substantially parallel to the transmission line (TL, TL11~TL1N, TL21~TL25) within a sensing area (SA) of the base plate (11), separated from the transmission line (TL, TL11~TL1N, TL21~TL25) by a first length (L1), and adapted for inducing the RF signal (RS, RS1) on the transmission line (TL, TL11~TL1N, TL21~TL25) to generate an induction signal (SS, SS1);
a controller (13), disposed on the base plate (11), electrically connected to the sensing line (SL, SL11-SLIN, SL21~SL23), and adapted for determining a state of the element under test (12) according to the induction signal (SS, SS1); **characterized in that** the radio frequency (RF) circuit (10) further comprises
a connector (14A, 14B), disposed on the base plate (11), coupled to the sensing line (SL, SL11~SL1N, SL21~SL23), and adapted for connecting to a sensor (16A, 16B);
wherein in response to the connector (14A, 14B) being connected to the sensor (16A, 16B), the sensor (16A, 16B) is adapted for generating a determination signal (DS) according to the induction signal (SS, SS1), and the controller (13) determines the state of the element under test (12) according to the determination signal (DS),
wherein the connector (14A, 14B) comprises:
a first conductive structure (141), electrically connected to the sensing line (SL, SL11~SL1N, SL21~SL23); and
a second conductive structure (142), electrically connected to a first voltage source on the base plate (11) to receive a first voltage;
wherein in response to the connector (14A, 14B) being not connected to the sensor (16A, 16B), the first conductive structure (141) and the second conductive structure (142) are in a clamping state;
in response to the connector (14A, 14B) being connected to the sensor (16A, 16B), the first conductive structure (141) and the second conductive structure (142) clamp the sensor (16A, 16B).

2. The radio frequency circuit (10) according to claim 1, wherein the first conductive structure (141) comprises:
a first conductor reed (141A);
a first conductor plate (141B), having a first end (e1) and a second end (e2) connected to the sensing line (SL, SL11~SL1N, SL21~SL23); and
a capacitor (C1, C2), electrically connected to the first end (e1) of the first conductor plate (141B) and the first conductor reed (141A) respectively;
wherein in response to the connector (14A, 14B) being not connected to the sensor (16A, 16B), the first conductor reed (141A) and the second conductive structure (142) form the clamping state.

3. The radio frequency circuit (10) according to claim 1, wherein the sensor (16A, 16B) comprises:
an amplifier (161, AMP), configured to amplify the induction signal (SS, SS1) to produce an output signal (OS); and
an analog to digital converter (162), coupled to the amplifier (161, AMP) and configured to convert the output signal (OS) output by the amplifier (161, AMP) into the determination signal (DS) in digital form.

4. The radio frequency circuit (10) according to claim 1, wherein the first length (L1) is one-eighth of a line width of the transmission line (TL, TL11~TL1N, TL21~TL25) to the line width of the transmission line (TL, TL11~TL1N, TL21~TL25).

5. The radio frequency circuit (10) according to claim 1, wherein
in response to the induction signal (SS, SS1) being not generated, the controller (13) is further configured to determine that the element under test (12) is in a malfunction state; and
in response to the induction signal (SS, SS1) being generated, the controller (13) is further configured to determine that the element under test (12) is in a normal state.

6. The radio frequency circuit (10) according to claim 1, wherein the base plate (11) further comprises a second surface (S2) opposite to the first surface, and the sensing line (SL, SL11~SLIN, SL21~SL23) is disposed on the second surface (S2).

7. The radio frequency circuit (10) according to claim 1, wherein
the controller (13) is further configured to connect a communication transceiver, and the communication transceiver is configured to transmit a malfunction state or the induction signal (SS, SS1) determined by the controller (13).

## Patentansprüche

1. Hochfrequenz (HF)-Schaltung (10), die eine Fehlererkennungsfähigkeit aufweist, umfassend:
eine Grundplatte (11), aufweisend eine erste Oberfläche (S1);
ein zu testendes Element (12), das auf der Grundplatte (11) angeordnet ist, umfassend einen Ausgangsanschluss (121) zur Ausgabe eines HF-Signals (RS, RS1);
eine Übertragungsleitung (TL, TL11~TL1N, TL21~TL25), die auf der ersten Oberfläche (S1) der Grundplatte (11) angeordnet ist und elektrisch mit dem Ausgangsanschluss (121) des zu testenden Elements (12) verbunden ist;
eine Erfassungsleitung (SL, SL11~SL1N, SL21∼SL23), die im Wesentlichen parallel zu der Übertragungsleitung (TL, TL11~TL1N, TL21~TL25) innerhalb eines Erfassungsbereichs (SA) der Basisplatte (11) verläuft, von der Übertragungsleitung (TL, TL11~TL1N, TL21~TL25) durch eine erste Länge (L1) getrennt ist und so angepasst ist, dass es das HF-Signal (RS, RS1) auf der Übertragungsleitung (TL, TL11~TL1N, TL21~TL25) induziert, um ein Induktionssignal (SS, SS1) zu erzeugen;
eine Steuerung (13), die auf der Basisplatte (11) angeordnet ist, elektrisch mit der Erfassungsleitung (SL, SL11∼SL1N, SL21∼SL23) verbunden ist und zur Bestimmung eines Zustands des zu testenden Elements (12) gemäß dem Induktionssignal (SS, SS1) angepasst ist; **dadurch gekennzeichnet, dass** die Hochfrequenz (HF)-Schaltung (10) ferner umfasst
einen Verbinder (14A, 14B), der auf der Basisplatte (11) angeordnet ist, der mit der Erfassungsleitung (SL, SL11∼SL1N, SL21∼SL23) gekoppelt ist und für den Anschluss an einen Sensor (16A, 16B) angepasst ist;
wobei der Sensor (16A, 16B) als Reaktion auf das Verbinden des Verbinders (14A, 14B) mit dem Sensor (16A, 16B) angepasst ist, um ein Bestimmungssignal (DS) gemäß dem Induktionssignal (SS, SS1) zu erzeugen, und die Steuerung (13) den Zustand des zu testenden Elements (12) gemäß dem Bestimmungssignal (DS) bestimmt,
der Verbinder (14A, 14B) umfasst:
eine erste leitende Struktur (141), die elektrisch mit der Erfassungsleitung (SL, SL11~SL1N, SL21∼SL23) verbunden ist; und
eine zweite leitende Struktur (142), die elektrisch mit einer ersten Spannungsquelle auf der Basisplatte (11) verbunden ist, um eine erste Spannung zu empfangen;
wobei sich die erste leitende Struktur (141) und die zweite leitende Struktur (142) in einem Klemmzustand befinden, wenn der Verbinder (14A, 14B) nicht mit dem Sensor (16A, 16B) verbunden ist;
als Reaktion auf das Verbinden des Verbinders (14A, 14B) mit dem Sensor (16A, 16B) klemmen die erste leitende Struktur (141) und die zweite leitende Struktur (142) den Sensor (16A, 16B) ein.

2. Hochfrequenz-Schaltung (10) gemäß Anspruch 1, wobei die erste leitende Struktur (141) umfasst:
ein erstes Leiter-Reed (141A);
eine erste Leiterplatte (141B) mit einem ersten Ende (e1) und einem zweiten Ende (e2), die mit der Erfassungsleitung (SL, SL11~SL1N, SL21∼SL23) verbunden ist; und
einen Kondensator (C1, C2), der elektrisch mit dem ersten Ende (e1) der ersten Leiterplatte (141B) bzw. dem ersten Leiter-Reed-Kontakt (141A) verbunden ist;
wobei in Reaktion darauf, dass der Verbinder (14A, 14B) nicht mit dem Sensor (16A, 16B) verbunden ist, der erste Leiter-Reed-Kontakt (141A) und die zweite leitende Struktur (142) den Klemmzustand bilden.

3. Hochfrequenz-Schaltung (10) gemäß Anspruch 1, wobei der Sensor (16A, 16B) umfasst:
einen Verstärker (161, AMP), der so konfiguriert ist, dass er das Induktionssignal (SS, SS1) verstärkt, um ein Ausgangssignal (OS) zu erzeugen; und
einen Analog-Digital-Wandler (162), der mit dem Verstärker (161, AMP) gekoppelt ist und so konfiguriert ist, dass er das vom Verstärker (161, AMP) ausgegebene Ausgangssignal (OS) in das Bestimmungssignal (DS) in digitaler Form umwandelt.

4. Hochfrequenz-Schaltung (10) gemäß Anspruch 1, wobei die erste Länge (L1) ein Achtel einer Leitungsbreite der Übertragungsleitung (TL, TL11~TL1N, TL21∼TL25) bis zur Leitungsbreite der Übertragungsleitung (TL, TL11~TL1N, TL21~TL25) beträgt.

5. Hochfrequenz-Schaltung (10) gemäß Anspruch 1, wobei
die Steuereinheit (13) ferner so konfiguriert ist, dass sie als Reaktion auf das nicht erzeugte Induktionssignal (SS, SS1) bestimmt, dass sich das zu testende Element (12) in einem Fehlfunktionszustand befindet; und
als Reaktion auf die Erzeugung des Induktionssignals (SS, SS1) die Steuereinheit (13) ferner so konfiguriert ist, dass sie bestimmt, dass sich das zu testende Element (12) in einem normalen Zustand befindet.

6. Hochfrequenz-Schaltung (10) gemäß Anspruch 1, wobei die Basisplatte (11) ferner eine zweite Oberfläche (S2) gegenüber der ersten Oberfläche umfasst und die Erfassungsleitung (SL, SL11~SL1N, SL21∼SL23) auf der zweiten Oberfläche (S2) angeordnet ist.

7. Hochfrequenz-Schaltung (10) gemäß Anspruch 1, wobei
die Steuereinheit (13) ferner so konfiguriert ist, dass sie einen Kommunikationstransceiver anschließt, und der Kommunikationstransceiver so konfiguriert ist, dass er einen Fehlfunktionszustand oder das Induktionssignal (SS, SS1), bestimmt durch die Steuerung (13), überträgt.

## Revendications

1. Circuit de radiofréquence (RF) (10) présentant une capacité de détection d'erreur, comprenant :
une plaque de base (11), présentant une première surface (S1) ;
un élément testé (12), disposé sur la plaque de base (11), comprenant un orifice de sortie (121) pour délivrer un signal RF (RS, RS1) ;
une ligne de transmission (TL, TL11~TL1N, TL21∼TL25), disposée sur la première surface (S1) de la plaque de base (11) et connectée électriquement à l'orifice de sortie (121) de l'élément testé (12) ;
une ligne de détection (SL, SL11~SL1N, SL21~SL23), sensiblement parallèle à la ligne de transmission (TL, TL11~TL1N, TL21~TL25) à l'intérieur d'une zone de détection (SA) de la plaque de base (11), séparée de la ligne de transmission (TL, TL11~TL1N, TL21∼TL25) d'une première longueur (L1), et adaptée pour induire le signal RF (RS, RS1) sur la ligne de transmission (TL, TL11~TL1N, TL21~TL25) pour générer un signal d'induction (SS, SS1) *;*
un dispositif de commande (13), disposé sur la plaque de base (11), connecté électriquement à la ligne de détection (SL, SL11~SL1N, SL21~SL23), et adapté pour déterminer un état de l'élément testé (12) en fonction du signal d'induction (SS, SS1) *;*
**caractérisé en ce que** le circuit de radiofréquence (RF) (10) comprend
en outre un connecteur (14A, 14B), disposé sur la plaque de base (11), couplé à la ligne de détection (SL, SL11~SL1N, SL21~SL23), et adapté pour se connecter à un capteur (16A, 16B) ;
dans lequel, en réponse au fait que le connecteur (14A, 14B) est connecté au capteur (16A, 16B), le capteur (16A, 16B) est adapté pour générer un signal de détermination (DS) en fonction du signal d'induction (SS, SS1), et le dispositif de commande (13) détermine l'état de l'élément testé (12) en fonction du signal de détermination (DS),
dans lequel le connecteur (14A, 14B) comprend :
une première structure conductrice (141), connectée électriquement à la ligne de détection (SL, SL11~SL1N, SL21~SL23) ; et
une deuxième structure conductrice (142), connectée électriquement à une première source de tension sur la plaque de base (11) pour recevoir une première tension ;
dans lequel, en réponse au fait que le connecteur (14A, 14B) n'est pas connecté au capteur (16A, 16B), la première structure conductrice (141) et la deuxième structure conductrice (142) sont dans un état de serrage ;
en réponse au fait que le connecteur (14A, 14B) est connecté au capteur (16A, 16B), la première structure conductrice (141) et la deuxième structure conductrice (142) serrent le capteur (16A, 16B).

2. Circuit de radiofréquence (10) selon la revendication 1, dans lequel la première structure conductrice (141) comprend :
un premier Reed conducteur (141A) ;
une première plaque conductrice (141B), présentant une première extrémité (e1) et une deuxième extrémité (e2) connectée à la ligne de détection (SL, SL11~SL1N, SL21∼SL23) ; et
un condensateur (C1, C2), connecté électriquement respectivement à la première extrémité (e1) de la première plaque conductrice (141B) et au premier Reed conducteur (141A) ;
dans lequel, en réponse au fait que le connecteur (14A, 14B) n'est pas connecté au capteur (16A, 16B), le premier Reed conducteur (141A) et la deuxième structure conductrice (142) forment l'état de serrage.

3. Circuit de radiofréquence (10) selon la revendication 1, dans lequel le capteur (16A, 16B) comprend :
un amplificateur (161, AMP), configuré pour amplifier le signal d'induction (SS, SS1) pour produire un signal de sortie (OS) ; et
un convertisseur analogique-numérique (162), couplé à l'amplificateur (161, AMP) et configuré pour convertir le signal de sortie (OS) délivré par l'amplificateur (161, AMP) en le signal de détermination (DS) sous forme numérique.

4. Circuit de radiofréquence (10) selon la revendication 1, dans lequel la première longueur (L1) est un huitième d'une largeur de ligne de la ligne de transmission (TL, TL11~TL1N, TL21~TL25) à la largeur de ligne de la ligne de transmission (TL, TL11~TL1N, TL21∼TL25).

5. Circuit de radiofréquence (10) selon la revendication 1, dans lequel
en réponse au fait que le signal d'induction (SS*,* SS1) n'est pas généré, le dispositif de commande (13) est en outre configuré pour déterminer que l'élément testé (12) est dans un état de dysfonctionnement ; et
en réponse au fait que le signal d'induction (SS, SS1) est généré, le dispositif de commande (13) est en outre configuré pour déterminer que l'élément testé (12) est dans un état normal.

6. Circuit de radiofréquence (10) selon la revendication 1, dans lequel la plaque de base (11) comprend en outre une deuxième surface (S2) opposée à la première surface, et la ligne de détection (SL, SL11~SL1N, SL21~SL23) est disposée sur la deuxième surface (S2).

7. Circuit de radiofréquence (10) selon la revendication 1, dans lequel
le dispositif de commande (13) est en outre configuré pour connecter un émetteur-récepteur de communication, et l'émetteur-récepteur de communication est configuré pour transmettre un état de dysfonctionnement ou le signal d'induction (SS, SS1) déterminé par le dispositif de commande (13).
